(19) Europäisches Patentamt
European Patent Office
Office européen des brevets

(11) **EP 4 757 539 A1**

(12) **DEMANDE DE BREVET EUROPEEN**

(43) Date de publication:
**10.06.2026 Bulletin 2026/24**

(21) Numéro de dépôt: **25216120.3**

(22) Date de dépôt: **17.11.2025**

(51) Classification Internationale des Brevets (IPC):
***H10F 19/80*** *(2025.01)*

(52) Classification Coopérative des Brevets (CPC):
**H10F 19/80; H10F 19/804**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **09.12.2024 FR 2413691**

(71) Demandeur: **Commissariat à l'Energie Atomique et aux Energies Alternatives**
**75015 Paris (FR)**

(72) Inventeurs:
• **CHAMBION, BERTRAND**
**38054 Grenoble cedex 09 (FR)**
• **CHAPOT, VALENTIN**
**73190 Apremont (FR)**

(74) Mandataire: **INNOV-GROUP**
**209 Avenue Berthelot**
**69007 Lyon (FR)**

(54) **PROCÉDÉ DE FABRICATION D'UNE COUCHE D ENCAPSULATION UTILISÉE POUR ENCAPSULER DES CELLULES PHOTOVOLTAÏQUES D'UN MODULE PHOTOVOLTAÏQUE**

(57) L'invention concerne un procédé de fabrication d'une couche d'encapsulation utilisée pour encapsuler des cellules photovoltaïques logées dans un module photovoltaïque, ce procédé consistant à :
- Utiliser une bande d'un film d'encapsulation, ladite bande s'étendant suivant un plan,
- Créer plusieurs fentes parallèles à travers ladite bande, suivant une première direction,
- Etirer la bande dans son plan et suivant une deuxième direction perpendiculaire à la première direction des fentes pour créer une structure en treillis formant ladite couche d'encapsulation.

Fig. 2C

EP 4 757 539 A1

## Description

## Domaine technique de l'invention

La présente invention se rapporte à un procédé de fabrication d'une couche d'encapsulation utilisée pour encapsuler les cellules photovoltaïques d'un module photovoltaïque. L'invention concerne également la couche d'encapsulation obtenue par le procédé, ainsi que le module photovoltaïque incluant une couche d'encapsulation de ce type et le procédé de fabrication de ce module photovoltaïque.

## Etat de la technique

Classiquement, un module photovoltaïque se présente sous la forme d'un panneau composé par l'assemblage de trois couches principales superposées et fixées entre elles :

- Une première couche, dite couche arrière (appelée couramment "backsheet"), formant un premier élément de protection en face arrière ;
- Une deuxième couche, dite couche intermédiaire ; cette couche intermédiaire comporte les cellules photovoltaïques, la connectique électrique entre les cellules et une enveloppe d'encapsulation arrangée autour des cellules photovoltaïques ;
- Une troisième couche, dite couche avant, formant un deuxième élément de protection en face avant ; cette couche avant est souvent en verre ou réalisée dans un polymère transparent pour être traversée par les rayons lumineux captés ;

L'enveloppe d'encapsulation est classiquement composée de deux couches d'un matériau polymère, positionnées de part et d'autre des cellules photovoltaïques.

Lors d'une opération de laminage, les deux couches d'encapsulation fondent pour ne former, après l'opération de laminage, qu'un seul ensemble solidifiée dans laquelle sont noyées les cellules photovoltaïques.

Récemment, pour certaines applications, l'idée est apparue de créer des modules photovoltaïques particulièrement légers. Dans ces applications, les exigences en termes de robustesse mécanique et de fiabilité du module sont allégées et la partie encapsulation peut être minimale afin d'optimiser la masse et le coût du système final. L'idée est d'intégrer un minimum de matière coté encapsulation, tout en maintenant son côté opérationnel, au moins sur une certaine durée. Pour certaines applications, le module photovoltaïque pourra même être à usage unique et considéré comme jetable.

Les demandes de brevets LU102080A1, CN110911514A et FR3081615A1 décrivent des modules photovoltaïques dans lesquelles la couche d'encapsulation comporte des évidements pour y positionner les cellules.

Le but de l'invention est de proposer une solution pour créer une couche d'encapsulation de module photovoltaïque qui soit particulièrement légère, afin de pouvoir obtenir in fine des modules photovoltaïques eux-mêmes légers, peu coûteux et éventuellement à usage unique.

## Exposé de l'invention

Ce but est atteint par un procédé de fabrication d'une couche d'encapsulation utilisée pour encapsuler des cellules photovoltaïques logées dans un module photovoltaïque, ce procédé consistant à :

- Utiliser une bande d'un film d'encapsulation, ladite bande s'étendant suivant un plan,
- Créer plusieurs fentes parallèles à travers ladite bande, suivant une première direction,
- Etirer la bande dans son plan et suivant une deuxième direction perpendiculaire à la première direction des fentes pour créer une structure en treillis formant ladite couche d'encapsulation.

Selon une réalisation avantageuse, les fentes sont créées sans retrait de matière. De ce fait, la fabrication est plus simple et permet de limiter les pertes de matière.

Selon une particularité, les fentes sont créées suivant plusieurs alignements parallèles entre eux et à la première direction, chaque alignement comportant plusieurs fentes, les alignements étant séparées entre eux d'une distance non nulle, suivant ladite deuxième direction. Ce principe permet de créer le treillis.

Selon une autre particularité, le procédé consiste à créer plus de deux alignements de fentes, la distance séparant deux alignements successifs étant constante, formant un pas déterminé.

Selon une autre particularité, les alignements de fentes sont disposés en quinconce suivant la deuxième direction.

Selon une autre particularité, les fentes d'un même alignement sont identiques.

Selon une autre particularité, les fentes de tous les alignements sont identiques.

Selon une autre particularité, le film d'encapsulation est réalisé dans un matériau de type polymère.

Selon une autre particularité, le matériau polymère est choisi parmi les copolymères d'acides, les ionomères, le poly(éthylène-acétate de vinyle), les acétals de vinyle, les polyuréthanes, les chlorures de polyvinyle, les polyéthylènes, les polyoléfines élastomères de copolymères, les copolymères d'$\alpha$-oléfines et des $\alpha$-, $\beta$- esters d'acide carboxylique à éthylénique, les élastomères de silicone et/ou les résines époxy.

L'invention concerne également une couche d'encapsulation employée dans un module photovoltaïque, ladite couche d'encapsulation étant destinée à recouvrir les cellules photovoltaïques du module photovoltaïque, cette couche d'encapsulation étant fabriquée selon le procédé tel que défini ci-dessus.

De manière avantageuse, la structure en treillis obtenue présente une maille carrée.

L'invention concerne également un module photovoltaïque comportant une couche arrière, une couche avant et une couche intermédiaire, agencée entre la couche avant et la couche arrière, la couche intermédiaire comportant des cellules photovoltaïques connectées entre elles et une enveloppe d'encapsulation, ladite enveloppe d'encapsulation étant formée à partir d'au moins une couche d'encapsulation telle que définie ci-dessus.

Selon une particularité, chaque maille de la structure en treillis de la couche d'encapsulation définit une zone centrale évidée, au moins une cellule photovoltaïque du module photovoltaïque étant positionnée en vis-à-vis d'une zone évidée de chaque maille de la structure en treillis.

De manière avantageuse, ladite enveloppe d'encapsulation est formée à partir d'une première couche d'encapsulation et d'une deuxième couche d'encapsulation, la première couche d'encapsulation et/ou la deuxième couche d'encapsulation étant telle que définie ci-dessus.

Selon une autre particularité, la structure en treillis de la première couche d'encapsulation est décalée suivant la deuxième direction par rapport à la structure en treillis de la deuxième couche d'encapsulation.

Selon une autre particularité, la structure en treillis de la première couche d'encapsulation présente une maille identique à celle de la structure en treillis de la deuxième couche d'encapsulation.

L'invention concerne un procédé de fabrication d'un module photovoltaïque tel que défini ci-dessus, ce procédé comportant :

- Une étape de fabrication de la première couche d'encapsulation selon le procédé tel que défini ci-dessus,
- Une étape de laminage à chaud de l'ensemble formé par la couche avant, ladite première couche d'encapsulation, ladite deuxième couche d'encapsulation et la couche arrière.

Selon une particularité, la deuxième couche d'encapsulation est également fabriquée selon le procédé tel que défini ci-dessus.

**Brève description des figures**

D'autres caractéristiques et avantages vont apparaître dans la description détaillée qui suit faite en regard des dessins annexés dans lesquels :

- Les figures 1A et 1B représentent de manière schématique un module photovoltaïque, respectivement en perspective et en vue de côté ;

- Les figures 2A à 2D illustrent les étapes du procédé de fabrication de l'invention ;
- Les figures 3A à 3C montrent différents détails de la structure en treillis obtenue par le procédé de fabrication de l'invention ;
- La figure 4 montre une architecture à deux structures en treillis superposées, chacune obtenue selon le procédé de fabrication de l'invention ;
- La figure 5 montre une structure en treillis obtenue selon le procédé de fabrication de l'invention, apposée sur les cellules photovoltaïques d'un module photovoltaïque ;

**Description détaillée d'au moins un mode de réalisation**

Dans la suite de la description, la face avant du module photovoltaïque M correspond à une face du module recevant les rayons lumineux et la face arrière correspond à la face qui est opposée à la face avant.

Le module photovoltaïque M comporte classiquement une forme externe rectangulaire, avec une longueur et une largeur dans deux dimensions et une épaisseur, faible par rapport à sa longueur et sa largeur, dans une troisième dimension. Dans la suite de la description, la longueur du module est définie suivant une direction X et la largeur du module est définie suivant une direction Y.

Dans la suite de la description, les termes arrière et avant sont donc à considérer en prenant un axe perpendiculaire à la surface du module et orientée de sa face arrière vers sa face avant.

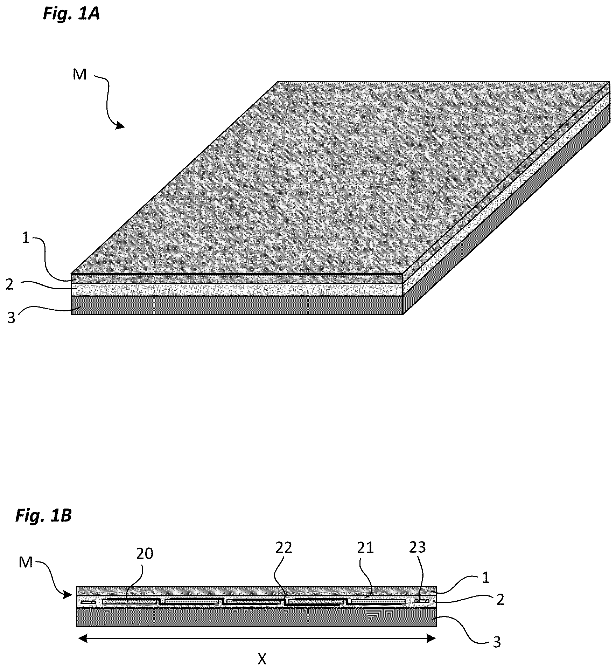

En référence à la figure 1A et à la figure 1B, de manière connue, un module photovoltaïque M comporte plusieurs couches superposées et assemblées entre elles :

- Une première couche, dite couche arrière 1 (appelée couramment "backsheet"), formant un premier élément de protection en face arrière ; cette couche arrière est habituellement réalisée dans un matériau de type polymère à une ou plusieurs strates ;
- Une deuxième couche, dite couche intermédiaire 2, intercalée entre la couche arrière 1 et la couche avant 3 (décrite ci-dessous), permettant l'assemblage d'un côté de la couche arrière 1 et de l'autre côté de la couche avant 3 ; cette couche intermédiaire 2 comporte les cellules photovoltaïques 20, la connectique électrique 22 et une enveloppe d'encapsulation 21 arrangée autour des cellules photovoltaïques ;
- La couche avant 3, formant un deuxième élément de protection en face avant ; cette couche avant 3 est habituellement réalisée en verre ou dans un polymère transparent ;

Il faut noter que sur les figures annexées, le module photovoltaïque M est représenté retourné, de sorte que sa face arrière est située au-dessus et la face avant est située au-dessous.

Pour des soucis de lisibilité sur les figures 1A et 1B annexées, les différentes couches du module ne sont pas représentées à l'échelle. A titre d'exemple, la couche arrière 1 peut présenter une épaisseur de quelques centaines de $\mu$m (par exemple comprise entre 10$\mu$m et 500$\mu$m, typiquement environ 350$\mu$m), la couche intermédiaire 2 peut présenter une épaisseur pouvant aller jusqu'à 1mm et la couche avant 3 peut présenter une épaisseur allant de 100$\mu$m à 4mm, selon le type de matériau employé (verre, polymère PMMA ou PC...).

La couche arrière 1 peut notamment assurer une fonction d'imperméabilité aux gaz et à l'eau, une fonction de protection/isolation électrique et une fonction de protection mécanique.

Dans la couche intermédiaire 2, l'enveloppe d'encapsulation 21 est classiquement réalisée dans un polymère formant un matériau sur lequel peuvent adhérer la couche arrière 1 d'un côté et la couche avant 3 de l'autre côté et permettre l'assemblage des trois couches entre elles. Les trois couches peuvent être assemblées entre elles par laminage à chaud, de sorte que la couche arrière 1 et la couche avant 3 viennent adhérer au matériau de l'enveloppe d'encapsulation, formant ainsi un empilement monobloc.

Dans la couche intermédiaire 2, les cellules photovoltaïques 20 sont connectées entre elles, en série/parallèle, formant plusieurs chaînes ("string" en anglais) de cellules. Des éléments de connexion électrique 22, par exemple en cuivre, permettent d'assurer les liaisons électriques entre les cellules 20 dans chaque chaîne.

L'enveloppe d'encapsulation peut présenter une épaisseur comprise entre 25$\mu$m et 2000$\mu$m, de préférence comprise entre 50$\mu$m et 500$\mu$m, de préférence comprise entre 100$\mu$m et 400$\mu$m.

Le module photovoltaïque M peut comporter un cadre (non représenté), par exemple en aluminium, agencé en périphérie de l'empilement pour rigidifier le module M. Pour la mise en œuvre de l'invention décrite ci-dessous, ce cadre, ainsi que la boîte de jonction électrique (non représentée) généralement fixée sur la face arrière du module M, sont préalablement retirés. Le procédé de l'invention est en effet dédié plus particulièrement au traitement de l'empilement de couches du module photovoltaïque M.

Par le terme «encapsulant », « encapsulé » ou « encapsulation », il faut comprendre que la pluralité de cellules photovoltaïques est disposée dans un volume, par exemple hermétiquement étanche vis-à-vis des liquides, au moins en partie formé par au moins deux couches de matériau(x) d'encapsulation, réunies entre elles après laminage pour former l'enveloppe d'encapsulation 21.

En effet, initialement, c'est-à-dire avant toute opération de laminage, l'enveloppe d'encapsulation 21 est constituée par au moins deux couches d'encapsulation, entre lesquelles la pluralité de cellules photovoltaïques est encapsulée. Cependant, dans une configuration moins fiable et bas coût, il serait possible d'utiliser une seule couche d'encapsulation, présente d'un seul côté. Les cellules photovoltaïques 20 viennent ainsi se fondre dans cette unique couche d'encapsulation lors de l'étape de laminage. Dans la suite de la description, on décrit une réalisation avantageuse à deux couches d'encapsulation.

Pendant l'opération de laminage des couches, les couches d'encapsulation fondent pour ne former, après l'opération de laminage, qu'une seule couche (ou ensemble) solidifiée dans laquelle sont noyées les cellules photovoltaïques.

Le film utilisé pour fabriquer la couche d'encapsulation peut être réalisé à partir d'au moins un matériau polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'$\alpha$-oléfines et des $\alpha$-, $\beta$- esters d'acide carboxylique à éthylénique tels que les copolymères éthylène-acrylate de méthyle et les copolymères éthylène-acrylate de butyle, les élastomères de silicone et/ou les résines époxy.

L'invention porte principalement sur une couche d'encapsulation présente dans un module photovoltaïque et sur un procédé particulier permettant de fabriquer cette couche d'encapsulation. L'invention peut être appliquée à l'unique couche d'encapsulation si le module photovoltaïque n'en comporte qu'une seule, à l'une des deux couches d'encapsulation ou aux deux couches d'encapsulation du module photovoltaïque.

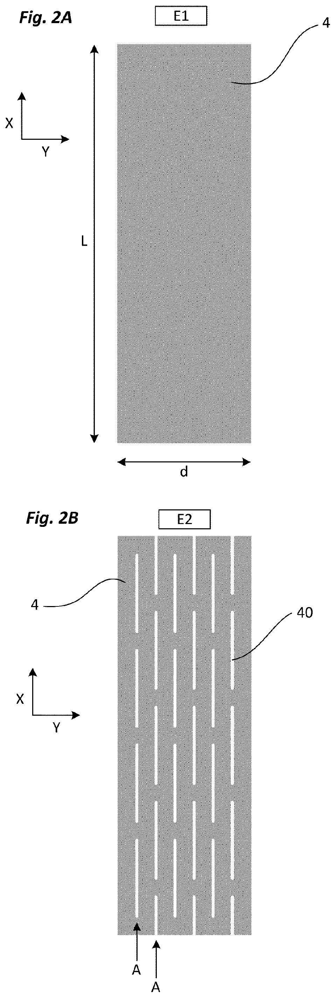

En référence aux figures 2A à 2D, ce procédé comporte les étapes décrites ci-dessous.

E1- Figure 2A : On part d'une bande 4 de matière d'un film d'encapsulation. Cette bande 4 présente une largeur d plus faible que la largeur D finale de la couche d'encapsulation et une longueur L au moins égale à la longueur finale de la couche d'encapsulation. La longueur L de la bande définit une première direction X et la largeur d de la bande 4 définit une deuxième direction Y, perpendiculaire à la première direction X.

E2 - Figure 2B : On effectue des fentes 40 à travers la bande 4, avantageusement sans retrait de matière. On peut également préciser que :

- Les fentes 40 sont réalisées dans le sens de la longueur de la bande (selon X) ;

- Les fentes 40 sont avantageusement toutes identiques ;

- Chaque fente 40 comporte une longueur déterminée ;

- Les fentes 40 sont réalisées suivant plusieurs alignements A juxtaposés suivant la largeur de la bande 4 (selon Y) ;

- Chaque alignement comporte au moins deux fentes ;

- Les alignements A sont avantageusement espacés d'un pas constant non nul, dans le sens de la largeur de la bande 4 ;

- D'un alignement à l'autre, les fentes 40 sont organisées en quinconce, c'est-à-dire qu'elles sont décalées dans le sens de la longueur de la bande ; D'un alignement à un autre, le décalage est avantageusement choisi d'un demi-pas ;

- Dans chaque alignement, les fentes 40 sont espacées d'un pas constant, dans le sens de la longueur de la bande 4 ;

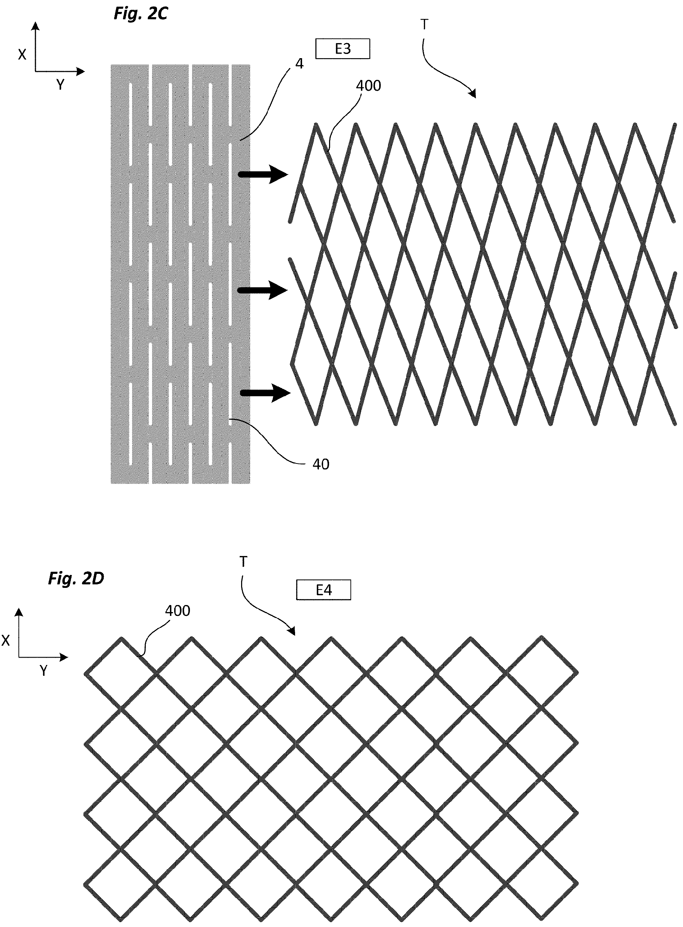

E3 - Figure 2C : Une fois les fentes 40 effectuées, on vient étirer mécaniquement la bande en la tirant suivant la deuxième direction Y. Grâce à la présence des fentes 40, on vient ainsi former une structure en treillis T, dont la maille 400 est créée par l'étirage de chaque fente 40. L'étirage mécanique de la bande est réalisé jusqu'à obtenir une largeur D suffisante, au moins égale à celle de la couche d'encapsulation (selon Y) que l'on souhaite obtenir (et qui doit correspondre au moins à la largeur finale du module photovoltaïque).

E4 - Figure 2D : La couche d'encapsulation obtenue prend donc la forme d'un treillis T. A titre d'exemple, avec des fentes 40 de tailles identiques et des alignements A de fentes espacées d'un pas constant et organisés en quinconce, le treillis T présente une maille 400 constante. Après étirage, cette maille 400 se présente sous la forme d'un losange et éventuellement d'un carré comme sur la figure 2D, si l'étirage est suffisant et adapté. La configuration en carré présente le double avantage de répartir la matière de manière homogène dans les deux directions X et Y.

Comme indiqué ci-dessus, la couche obtenue, après étirage mécanique de la bande de film initiale, pourra être employée pour former l'unique couche d'encapsulation d'un module photovoltaïque, ou l'une et/ou l'autre des deux couches d'encapsulation positionnées de part et d'autre des cellules photovoltaïques 20, avant l'étape de laminage.

Pour la réalisation d'un treillis T, selon le principe de l'invention, plusieurs paramètres doivent être choisis :

- La largeur d de la bande 4 de film d'encapsulation utilisée initialement pour obtenir la maille 400 finale voulue et obtenir une couche d'encapsulation finale d'une largeur D suffisante ;

- Le nombre n de mailles nécessaires pour obtenir la largeur D finale de la couche d'encapsulation du module photovoltaïque ;

- La longueur de chaque fente 40 ;

- Le pas constant existant entre deux alignements A successifs ;

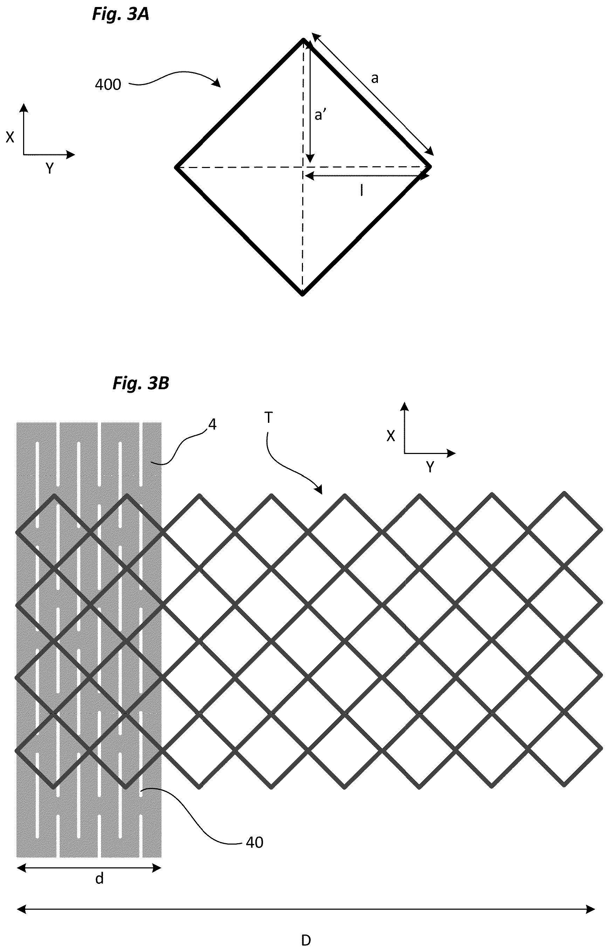

La figure 3A montre un exemple de réalisation d'une maille 400 de forme carrée, ayant les paramètres suivants :

- a correspond à la longueur du côté de la maille carrée que l'on souhaite obtenir ;

- a' correspond à la longueur de la demi-diagonale de la maille carrée que l'on souhaite obtenir, dans le sens de la longueur de la bande (selon X) ;

- *l* correspond à la longueur de la demi-diagonale de la maille carrée que l'on souhaite obtenir, dans le sens de la largeur de la bande (selon Y) ;

**La largeur de bande :**

En liaison avec la figure 3B, pour déterminer la largeur d de la bande 4 à utiliser initialement, il est nécessaire de connaître le facteur d'allègement F que l'on souhaite obtenir pour la couche d'encapsulation finale. Ce facteur d'allègement F correspond, pour une maille 400 finale de forme carrée, à :

$$F = \frac{D}{d} * \frac{a'}{a}$$

Dans laquelle :

- F correspond au facteur d'allègement désiré ;

- D correspond à la largeur finale désirée de la couche d'encapsulation ;

- d correspond à la largeur de la bande 4 de film d'encapsulation utilisée initialement, avant étirage ;

- a correspond à la longueur du côté de la maille 400 carrée que l'on souhaite obtenir ;

- a' correspond à la longueur de la demi-diagonale de la maille carrée que l'on souhaite obtenir, dans le sens de la longueur de la bande (selon X) ;

Pour rappel, en référence à la figure 3A, pour une maille carrée, on a :

$$a^2 = 2l^2$$

Dans laquelle :

- *l* correspond à la longueur de la demi-diagonale de la maille carrée que l'on souhaite obtenir, dans le sens de la largeur de la bande ;

Dans une maille carrée, on a :

$$a = \sqrt{2l^2} \text{ et } a' = l$$

Pour une maille carrée, le facteur d'allègement s'exprime donc de la manière suivante :

$$F = \frac{D}{d} * \frac{\sqrt{2}}{2}$$

Selon le facteur d'allègement F choisi, on peut en déduire la largeur d initiale nécessaire pour obtenir la couche d'encapsulation de largeur D ayant la forme d'un treillis T de maille 400 carrée de côté a.

**Le nombre de mailles** :

En choisissant une maille carrée, on a l'expression suivante :

$$D - d = n * 2l$$

Dans laquelle :

- n correspond au nombre de mailles que l'on souhaite obtenir ;

- *l* correspond à la longueur de la demi-diagonale de la maille dans le sens de la largeur de la bande et correspond donc au niveau d'étirage que l'on va appliquer sur la bande ;

Et on peut ainsi en déduire :

$$l = \frac{(D - d)}{2n}$$

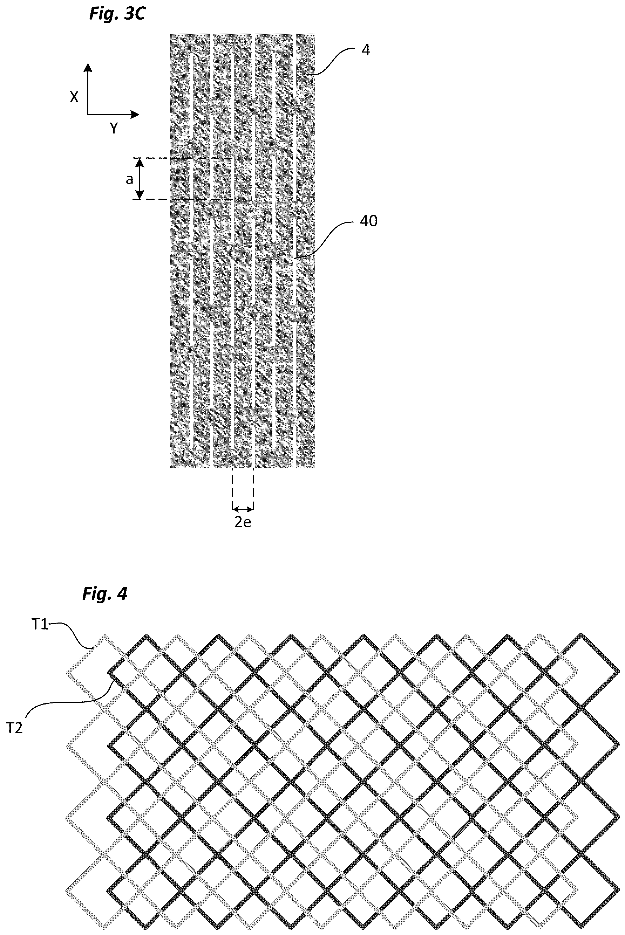

**La longueur de chaque fente (figure 3C)** :

En liaison avec la figure 3C, dans le cas d'une maille carrée, la longueur de chaque fente correspond à deux fois la longueur du côté de la maille carrée, c'est-à-dire à 2*a.

Comme indiqué ci-dessus, on a : $a = \sqrt{2l^2}$

**Le pas entre deux alignements successifs (figure 3C)** :

En liaison avec la figure 3C, ce pas correspond à 2e et est fonction de la largeur totale D de la couche d'encapsulation obtenue, après étirage, et du nombre n de mailles du treillis T obtenu. Il est ainsi régi par la relation suivante :

$$2e = \frac{D}{(n)}$$

Dans laquelle :

- e correspond au pas constant existant entre deux alignements successifs ;

- D correspond à la largeur de la couche d'encapsulation ;

- n correspond au nombre total de mailles du treillis T ;

De manière simplifiée, la couche d'encapsulation a été décrite avec un treillis T à maille 400 carrée. Cette architecture permet en effet une répartition uniforme de la matière, dans les deux directions X, Y du plan de la couche d'encapsulation, après étirage.

Cependant, le principe peut s'appliquer à toute autre forme de maille, losange, hexagonale,...

- La démonstration est généralisable à toute autre forme de maille (losange ou autre) mais dans ce cas la matière sera répartie selon une direction privilégiée, ce qui peut s'avérer intéressant si l'on souhaite renforcer la structure mécanique dans la direction choisie.

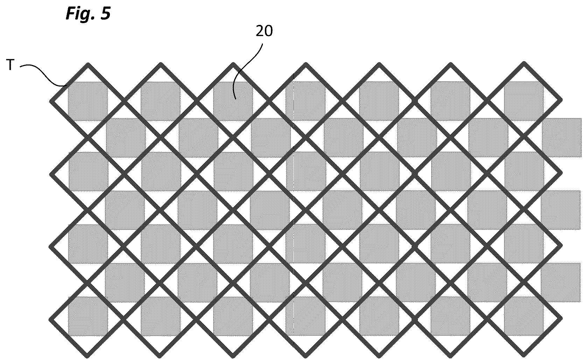

- Lors de la disposition de la couche d'encapsulation sur les cellules photovoltaïques 20, le positionnement des mailles par rapport aux cellules photovoltaïques 20 peut être effectué pour laisser une zone évidée sans matériau encapsulant et suffisante pour effectuer une reprise de contact ; ce principe est illustré par la figure 5 ;

- Dans le cas ou la couche d'encapsulation finale doit être continue, la recette de laminage sera ajustée, pour permettre un temps allongé de fluage de la matière (typiquement palier de température allongé) ; Il faut noter que la face avant du module photovoltaïque peut être placée vers le bas, en direction d'un plateau chauffant plan et rigide du laminateur, ce qui favorisera la bonne répartition de la couche d'encapsulation sur la surface, en vue de former une seule couche continue ;

- Une fois étirée, la structure en treillis T peut avoir tendance à vouloir revenir vers sa position initiale. Une relaxation thermique de la structure étirée peut être intégrée avant le laminage de l'empilement final (stockage thermique en position étirée, ou pré-laminage).

- L'utilisation de deux treillis superposés tel que décrit sur la figure 4 permet, à quantité de matière constante, de pré-répartir initialement la matière sur un maillage deux fois plus fin, ce qui peut faciliter le fluage de l'encapsulant lors de l'étape de lamination et permettre d'obtenir une couche continue.

- Dans ce dernier cas, deux treillis présentant des aspects, textures, couleurs ou motifs visuels différents peuvent être utilisés pour obtenir un rendu visuel spécifique après mise en forme et lamination (exemple module PV esthétique, module « semi coloré », ou motif type camouflage.)

**Revendications**

1. Procédé de fabrication d'une couche d'encapsulation utilisée pour encapsuler des cellules photovoltaïques logées dans un module photovoltaïque, ce procédé consistant à :

   - Utiliser une bande (4) d'un film d'encapsulation, ladite bande (4) s'étendant suivant un plan,
   - Créer plusieurs fentes (40) parallèles à travers ladite bande (4), suivant une première direction (X),
   - Etirer la bande (4) dans son plan et suivant une deuxième direction (Y) perpendiculaire à la première direction (X) des fentes pour créer une structure en treillis (T) formant ladite couche d'encapsulation.

2. Procédé selon la revendication 1, **caractérisé en ce que** les fentes (40) sont créées sans retrait de matière.

3. Procédé selon la revendication 1 ou 2, **caractérisé en ce que** les fentes (40) sont créées suivant plusieurs alignements (A) parallèles entre eux et à la première direction (X), chaque alignement (A) comportant plusieurs fentes, les alignements étant séparées entre eux d'une distance non nulle, suivant ladite deuxième direction (Y).

4. Procédé selon la revendication 3, **caractérisé en ce qu'**il consiste à créer plus de deux alignements (A) de fentes et **en ce que** la distance séparant deux alignements successifs est constante, formant un pas déterminé.

5. Procédé selon la revendication 4, **caractérisé en ce que** les alignements de fentes sont disposés en quinconce suivant la deuxième direction (Y).

6. Procédé selon l'une des revendications 3 à 5, **caractérisé en ce que** les fentes (40) d'un même alignement sont identiques.

7. Procédé selon l'une des revendications 3 à 6, **caractérisé en ce que** les fentes (40) de tous les alignements sont identiques.

8. Procédé selon l'une des revendications 1 à 7, **caractérisé en ce que** le film d'encapsulation est réalisé dans un matériau de type polymère.

9. Procédé selon la revendication 8, **caractérisé en ce que** le matériau polymère est choisi parmi les copolymères d'acides, les ionomères, le poly(éthylène-acétate de vinyle), les acétals de vinyle, les polyuréthanes, les chlorures de polyvinyle, les polyéthylènes, les polyoléfines élastomères de copolymères, les copolymères d'$\alpha$-oléfines et des $\alpha$-, $\beta$- esters d'acide carboxylique à éthylénique, les élastomères de silicone et/ou les résines époxy.

10. Couche d'encapsulation employée dans un module photovoltaïque, ladite couche d'encapsulation étant destinée à recouvrir les cellules photovoltaïques (20) du module photovoltaïque (M), **caractérisé en ce que** la couche d'encapsulation est fabriquée selon le procédé tel que défini dans l'une des revendications 1 à 9.

11. Couche d'encapsulation selon la revendication 10, **caractérisée en ce que** la structure en treillis (T) obtenue présente une maille (400) carrée.

12. Module photovoltaïque comportant une couche arrière, une couche avant et une couche intermédiaire (2), agencée entre la couche avant et la couche arrière, la couche intermédiaire comportant des cellules photovoltaïques (20) connectées entre elles et une enveloppe d'encapsulation (21), ladite enveloppe d'encapsulation étant formée à partir d'au moins une couche d'encapsulation, **caractérisée en ce que** ladite au moins une couche d'encapsulation est telle que définie dans la revendication 10 ou 11.

13. Module photovoltaïque selon la revendication 12, **caractérisé en ce que** chaque maille (400) de la structure en treillis formée par ladite au moins une couche d'encapsulation définit une zone centrale évidée et **en ce qu'**au moins une cellule photovoltaïque (20) du module photovoltaïque est positionnée en vis-à-vis d'une zone évidée de chaque maille (400) de la structure en treillis.

14. Module photovoltaïque selon la revendication 12 ou 13, **caractérisé en ce que** ladite enveloppe d'encapsulation est formée à partir d'une première couche d'encapsulation et d'une deuxième couche d'encapsulation, et **en ce que** la première couche d'encapsulation et/ou la deuxième couche d'encapsulation est telle que définie dans la revendication 10 ou 11.

15. Module selon la revendication 14, **caractérisé en ce que** la structure en treillis (T1) de la première couche d'encapsulation est décalée suivant la deuxième direction par rapport à la structure en treillis (T2) de la deuxième couche d'encapsulation.

16. Module selon la revendication 15, **caractérisé en ce que** la structure en treillis (T1) de la première couche d'encapsulation présente une maille identique à celle de la structure en treillis (T2) de la deuxième couche d'encapsulation.

17. Procédé de fabrication d'un module photovoltaïque tel que défini dans l'une des revendications 14 à 16, **caractérisé en ce qu'**il comporte :

    - Une étape de fabrication de la première couche d'encapsulation selon le procédé de fabrication tel que défini dans l'une des revendications 1 à 9,
    - Une étape de laminage à chaud de l'ensemble formé par la couche avant, ladite première couche d'encapsulation, ladite deuxième couche d'encapsulation et la couche arrière.

18. Procédé de fabrication selon la revendication 17, **caractérisé en ce que** la deuxième couche d'encapsulation est également fabriquée selon le procédé tel que défini dans l'une revendications 1 à 9.

**Fig. 1A**

**Fig. 1B**

*Fig. 2A*

E1

4

X
Y

L

d

*Fig. 2B*

E2

4

40

X
Y

A
A

*Fig. 2C*

E3

T

4

400

40

X
Y

*Fig. 2D*

T

E4

400

X
Y

**Fig. 3A**

400

**Fig. 3B**

Fig. 3C

Fig. 4

**Fig. 5**

| | Europäisches Patentamt European Patent Office Office européen des brevets | **RAPPORT DE RECHERCHE EUROPEENNE** | Numéro de la demande<br>**EP 25 21 6120** |
|---|---|---|---|

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (IPC) |
|---|---|---|---|
| X | LU 102 080 A1 (UNIV SOOCHOW [CN])<br>17 novembre 2020 (2020-11-17) | 10-14 | INV.<br>H10F19/80 |
| A | * pages 15-16; figure 8 * | 1-9,<br>15-18 | |
| | ----- | | |
| X | CN 110 911 514 A (YU CHANGYUE)<br>24 mars 2020 (2020-03-24)<br>* figure 1 * | 10,11 | |
| | ----- | | |
| A | FR 3 081 615 A1 (COMMISSARIAT ENERGIE<br>ATOMIQUE [FR])<br>29 novembre 2019 (2019-11-29)<br>* page 14; figures 4-5 * | 1-18 | |
| | ----- | | |
| A | US 2014/360563 A1 (PEARCE DAVID B [US] ET<br>AL) 11 décembre 2014 (2014-12-11)<br>* alinéas [0034] - [0041]; figures 2-4 *<br>----- | 1 | |

**DOMAINES TECHNIQUES RECHERCHES (IPC)**

H10F

Le présent rapport a été établi pour toutes les revendications

| Lieu de la recherche | Date d'achèvement de la recherche | Examinateur |
|---|---|---|
| Berlin | 27 avril 2026 | Persat, Nathalie |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 25 21 6120

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-04-2026

| Document brevet cité au rapport de recherche | | Date de publication | Membre(s) de la famille de brevet(s) | | Date de publication |
|---|---|---|---|---|---|
| LU 102080 | A1 | 17-11-2020 | CN | 109994564 A | 09-07-2019 |
| | | | LU | 102080 B1 | 29-01-2021 |
| | | | WO | 2020233036 A1 | 26-11-2020 |
| CN 110911514 | A | 24-03-2020 | AUCUN | | |
| FR 3081615 | A1 | 29-11-2019 | CN | 112189264 A | 05-01-2021 |
| | | | EP | 3776668 A1 | 17-02-2021 |
| | | | ES | 2924337 T3 | 06-10-2022 |
| | | | FR | 3081615 A1 | 29-11-2019 |
| | | | IL | 278537 A | 31-12-2020 |
| | | | JP | 7408573 B2 | 05-01-2024 |
| | | | JP | 2021525001 A | 16-09-2021 |
| | | | SG | 11202011406X A | 30-12-2020 |
| | | | US | 2021249549 A1 | 12-08-2021 |
| | | | WO | 2019224458 A1 | 28-11-2019 |
| US 2014360563 | A1 | 11-12-2014 | CN | 103140942 A | 05-06-2013 |
| | | | EP | 2577741 A2 | 10-04-2013 |
| | | | JP | 2013527627 A | 27-06-2013 |
| | | | JP | 2017143303 A | 17-08-2017 |
| | | | TW | 201218409 A | 01-05-2012 |
| | | | US | 2011300661 A1 | 08-12-2011 |
| | | | US | 2014360563 A1 | 11-12-2014 |
| | | | WO | 2011153321 A2 | 08-12-2011 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- LU 102080 A1
- CN 110911514 A

- FR 3081615 A1